# EUROPÄISCHE PATENTSCHRIFT

(11) **EP 1 233 935 B1**
(45) Veröffentlichungstag und Bekanntmachung des Hinweises auf die Patenterteilung: **14.05.2003**
(21) Anmeldenummer: 00960218.6
(22) Anmeldetag: 20.09.2000
(51) Int. Cl.: C04B 37/02, H01L 23/373, B23K 35/30

(54) **VERFAHREN ZUR FESTLEGUNG EINES AUS METALL-MATRIX-COMPOSITE-(MMC) MATERIAL GEBILDETEN KÖRPERS AUF EINEM KERAMISCHEN KÖRPER**
METHOD FOR ATTACHING A BODY, WHICH IS COMPRISED OF A METAL MATRIX COMPOSITE (MMC) MATERIAL, TO A CERAMIC BODY
PROCEDE DE FIXATION D'UN CORPS CONSTITUE DE MATERIAU COMPOSITE A MATRICE METALLIQUE (MMC) SUR UN CORPS EN CERAMIQUE

(30) Priorität: 17.11.1999 AT 194699
(43) Veröffentlichungstag der Anmeldung: 28.08.2002
(73) Patentinhaber: ELECTROVAC FABRIKATION ELEKTROTECHNISCHER SPEZIALARTIKEL GESELLSCHAFT M.B.H., 3400 Klosterneuburg (AT)
(72) Erfinder: SCHMITT, Theodore, Nicolas, A-1230 Wien (AT)
(74) Vertreter: Gibler, Ferdinand, Dipl.Ing. Dr. techn.
(86) Internationale Anmeldenummer: AT0000250
(87) Internationale Veröffentlichungsnummer: WO01036349

(56) Entgegenhaltungen:
- EP-A- 0 363 286
- EP-A- 0 455 229
- EP-A- 0 839 598
- US-A- 4 611 745
- US-A- 4 729 504
- PATENT ABSTRACTS OF JAPAN vol. 1996, no. 11, 29. November 1996 (1996-11-29) -& JP 08 191120 A (HITACHI LTD), 23. Juli 1996 (1996-07-23)
- W.HUFNAGEL: "Aluminium Taschenbuch" 1983 , ALUMINIUM VERLAG , DUSSELDORF, DE XP002164300 Seite 607 -Seite 618

## Beschreibung

Die Erfindung betrifft ein Verfahren zur Verbindung eines aus einem Metall-Matrix-Composite- (MMC-) Material gebildeten Körpers, insbesondere eines Kühlkörpers, oder eines aus Kupfer gebildeten Körpers mit einem keramischen Körper, insbesondere einer keramischen Leiterplatte, wobei die am MMC-Körper oder Kupfer-Körper anliegende Oberfläche des keramischen Körpers mit einem ersten Metall beschichtet wird.

Mit dem im Stand der Technik bekannten Begriff "Metall-Matrix-Composite- (MMC-)Material" wird ein Werkstoff bezeichnet, welcher aus zwei Komponenten besteht. Die erste Komponente ist ein Metall, auch als Matrix-Metall bezeichnet. In dieses Metall ist als zweite Komponente ein Verstärkungsmaterial eingebettet. Dieses, zumeist aus einem keramischen Material bestehende Verstärkungsmaterial kann in Gestalt einer Vielzahl von Einzelteilchen (Partikeln, Fasern, gröberen Teilen) oder in Gestalt eines einzigen oder einiger weniger einstückiger, aber poröser Teile vorliegen. In beiden Fällen ist das Verstärkungsmaterial von Matrix-Metall umschlossen bzw. durchdrungen, sodaß beide Komponenten gut miteinander vermischt sind.

Derartige Verbundwerkstoffe weisen besonders gute Eigenschaften, wie hohe mechanische Festigkeit, gute Temperaturleitfähigkeit, gute Temperaturwechsel-Beständigkeit, niedriger Ausdehnungskoeffizient und dgl. auf. Das Ausmaß dieser Eigenschaften, d.h. die konkreten Werte der Festigkeit, der Temperaturleitfähigkeit usw. lassen sich durch gezielte Auswahl des Verstärkungsmateriales und des Matrix-Metalles sowie des Mischungsverhältnisses dieser beiden Komponenten einstellen.

Im Stand der Technik sind mehrere Verfahren zur Herstellung derartiger MMC-Materialien bekannt, sodaß ein detailliertes Eingehen auf diese Herstellungsverfahren entbehrlich erscheint, zumal die gegenständliche Erfindung nicht auf ein solches Herstellungsverfahren abgestellt ist.

Eines der vielen Anwendungsgebiete von MMC-Körpern liegt in deren Verwendung als Kühlkörper für elektrische/elektronische Schaltungen. Dazu ist es notwendig, sie auf der Leiterplatte der zu kühlenden elektrischen/elektronischen Schaltung festzulegen.

Leiterplatten zur Aufnahme von elektrischen/elektronischen Schaltungen, insbesondere von Hochleistungsbaugruppen, wie z.B. Gleichrichterschaltungen umfassend IGBTs zur Bereitstellung von Gleichspannung für Gleichstrommaschinen, werden in zunehmendem Maß aus keramischem Material gebildet. Die auf ihnen festgelegten Leiterbahnen bestehen in der Regel aus Kupfer und werden vorzugsweise mittels eines Direct-Copper-Bonding- (DCB-)Verfahrens auf der Oberfläche festgelegt.

Die Verbindung eines aus MMC-Material gebildeten Kühlkörpers auf dieser keramischen Leiterplatte erfolgt nach bisher bekanntem Stand der Technik durch Verlöten der keramischen Leiterplatte mit diesem Kühlkörper. Dazu wird die am MMC-Körper anliegende Oberfläche des keramischen Körpers mit einem Metall beschichtet, das mit dem Matrix-Metall des Kühlkörpers verlötbar ist. Diese Metall ist in der Regel Kupfer. Anschließend werden der MMC-Kühlkörper und die metallbeschichtete keramische Leiterplatte unter Zuhilfenahme eines Lotes miteinander verlötet.

So beschreibt z.B. die **EP-A-839 598** die Verbindung einer Kupferplatte mit einem AlN-Substrat unter Zuhilfenahme eines Lotes in technisch einfacher und umweltfreundlicher Weise. Als Lot dient dabei eine Paste, mit der das Substrat beschichtet wird. Nach der Beschichtung wird die Cu-Platte aufgelegt und das Ganze auf 830°C erhitzt. Gemäß einem Vergleichsbeispiel besteht die Lötpaste aus drei Metallpulvem (Ag, Cu und Ti), die eine Legierung bilden.

Die Verwendung dieses Lotes hat einige wesentliche Nachteile: Zum einen stellt die Verwendung eines Lotes einen zusätzlichen Materialaufwand dar, zum anderen muß das Lot zwischen die beiden zu verlötenden Körper eingebracht werden, was einen entsprechenden zusätzlichen produktionstechnischen Schritt erfordert. Desweiteren besitzt das Lot eine relativ schlechte Wärmeleitfähigkeit, verhindert also ein ungestörtes Fließen der Wärme zu dem Kühlkörper (Au80Sn20 = 58W/mK; Au88Ge12 = 44W/mK; Sn66Pb36Ag2 = 54W/mK). Schließlich sind die zur Herstellung der im gegenständlichen Fall benötigten Lötverbindungen geeigneten Lote bleihältig, womit bei deren Verarbeitung für Mensch und Umwelt giftige Dämpfe entstehen.

Neben der eben erörterten Problematik der Verbindung eines MMC-Körpers mit einer Keramik wurde im Stand der Technik bisher die Festlegung eines Kupferkörpers bzw. einer Kupferschicht auf einer Keramik, insbesondere auf Aluminiumnitrid, nicht zufriedenstellend gelöst.

Es ist Aufgabe der gegenständlichen Erfindung, ein Verfahren der eingangs angeführten Art anzugeben, bei welchem die erörterten Probleme vermieden werden, welches also die Verbindung eines aus einem Metall-Matrix-Composite- (MMC-)Material oder aus Kupfer gebildeten Körpers mit einem keramischen Körper in technisch einfacher und umweltfreundlicher Weise ermöglicht.

Erfindungsgemäß wird dies dadurch erreicht, daß der keramische Körper auf den MMC- oder Kupfer-Körper aufgelegt wird und daß die beiden Körper über die eutektische Temperatur des Systems gebildet aus dem Matrix-Metall des MMC-Körpers oder dem Kupfer des Kupfer-Körpers und dem auf die Oberfläche des keramischen Körpers aufgebrachten ersten Metall erhitzt und anschließend auf Raumtemperatur abkühlen gelassen werden.

Diese Vorgangsweise kommt völlig ohne einen Lötvorgang aus, womit sämtliche mit dieser Verbindungstechnik verbundenen Schwierigkeiten und Nachteile von vornherein vermieden sind. Darüberhinaus weist eine erfindungsgemäß entstehende eutektische Verbindung eine weitaus höhere Festigkeit und einen höheren Schmelzpunkt auf, als eine Lötstelle, womit der entstehende Verbund aus MMC-Körper oder Kupfer-Körper und keramischem Körper in einem weiteren Bereich, insbesondere bei höheren Temperaturen, als die bisher durch Verlöten hergestellten Verbünde eingesetzt werden kann.

Die mittels diesem Verfahren hergestellte Verbindung zwischen einem Kupfer-Körper und einem keramischen, insbesondere aus AlN gebildeten Körper, ist wesentlich besser, als die mit den bisher bekannten Verfahren erzielten Ergebnissen.

Gemäß einer bevorzugten Ausführungsweise der Erfindung kann vorgesehen sein, daß vor dem Auflegen des keramischen Körpers auf den MMC-Körper auf die am keramischen Körper anliegende Oberfläche des MMC-Körpers ein zweites Metall aufgebracht wird und daß die beiden Körper über die eutektische Temperatur des Systems gebildet aus dem Matrix-Metall des MMC-Körpers, dem auf die Oberfläche des keramischen Körpers aufgebrachten ersten Metall und dem auf die Oberfläche des MMC-Körpers aufgebrachten zweiten Metall erhitzt und anschließend auf Raumtemperatur abkühlen gelassen werden.

Bei richtiger Abstimmung der drei Metalle (erstes Metall am keramischen Körper, zweites Metall am MMC-Körper und Matrix-Metall des MMC-Körpers) aufeinander können diese ein ternäres Eutektikum bilden, welches eine besonders innige Verbindung von keramischem Körper und MMC-Körper herstellt.

In weiterer Ausgestaltung der Erfindung kann vorgesehen sein, daß das Matrix-Metall des MMC-Körpers durch Aluminium oder eine Aluminiumlegierung gebildet wird.

Derartige Verbünde weisen eine besonders gute thermische Leitfähigkeit auf, weshalb sie sich sehr gut zur Bildung von Kühlkörpern eignen.

Weiters kann vorgesehen sein, daß das Verstärkungsmaterial des MMC-Körpers durch eine Keramik, insbesondere durch SiC gebildet wird.

Ein MMC-Körper mit diesem Verstärkungsmaterial weist sehr hohe mechanische Festigkeitswerte auf. Insbesondere in Kombination mit einem aluminiumhältigen Matrix-Metall ergibt sich daneben eine gute thermische Leitfähigkeit, welche den MMC-Körper zur Bildung eines Kühlkörpers geeignet macht.

In weiterer Ausgestaltung der Erfindung kann vorgesehen sein, daß die am MMC-Körper anliegende Oberfläche des keramischen Körpers mit Kupfer beschichtet wird.

Weiters kann vorgesehen sein, daß auf die am keramischen Körper anliegende Oberfläche des MMC-Körpers Kupfer aufgebracht wird.

Zwischen MMC-Körper und keramischem Körper befinden sich insgesamt drei Metalle (Matrixmetall des MMC-Körpers, erstes Metall auf der Oberfläche des keramischen Körpers und zweites Metall auf der Oberfläche des MMC-Körpers). Hier können nun das zusätzlich auf den MMC-Körper aufgebrachte Metall und das Metall auf der Keramik miteinander reagieren und ein Eutektikum bilden. Gleichzeitig reagiert aber auch das zusätzlich auf den MMC-Körper aufgebrachte Metall mit dem Matrix-Metall des MMC-Körpers, wobei ebenfalls ein Eutektikum gebildet wird. Diese Verbindungen können dann wieder untereinander reagiern. Im günstigsten Fall bildet sich ein ternäres Eutektikum aus. Kupfer ist besonders gut geeignet, eine Vielzahl von Material-Kombinationen zu einem solchen ternären System zu ergänzen, womit die Verwendung einer Kupferschicht eine universelle Anwendbarkeit des erfindungsgemäßen Verfahrens erlaubt.

In diesem Zusammenhang hat es sich als vorteilhaft erwiesen, daß die Beschichtung der am MMC-Körper anliegenden Oberfläche des keramischen Körpers mittels eines Direct-Copper-Bonding- (DCB-)Verfahrens durchgeführt wird.

Mit einem solchen Verfahren kann eine besonders innige Verbindung der Kupferschicht am keramischen Körper erreicht werden.

Wenn mit dem erfindungsgemäßen Verfahren ein Kupfer-Körper mit einem keramischen Körper verbunden wird, kann vorgesehen sein, daß die am Kupfer-Körper anliegende Oberfläche des keramischen Körpers mit Aluminium beschichtet wird, wobei in diesem Zusammenhang weiters vorgesehen sein kann, daß auf die Aluminiumschicht eine Kupferschicht aufgebracht wird, beispielsweise mittels elektrochemischen Methoden, wie insbesondere mittels eines galvanischen Verfahrens.

Aluminium und Kupfer bilden bei 548°C ein Eutektikum, sodaß mittels einer Aluminiumbeschichtung der Keramik die Voraussetzungen für den korrekten Ablauf des erfindungsgemäßen Verfahrens geschaffen werden können.

Nach einer anderen Ausgestaltungsweise der Erfindung kann vorgesehen sein, daß auf die am keramischen Körper anliegende Oberfläche des MMC-Körpers Zink, Zinn, Germanium od. dgl. aufgebracht wird.

Diese Materialien sind insbesondere geeignet, ein aluminiumhältiges Matrix-Metall und eine Kupferbeschichtung des MMC-Körpers zu einem einen eutektischen Punkt aufweisenden ternären System zu ergänzen.

Dabei kann vorgesehen sein, daß das Aufbringen des zweiten Metalles auf die am keramischen Körper anliegende Oberfläche des MMC-Körpers mittels eines galvanischen Verfahrens durchgeführt wird.

Dieses Beschichtungverfahren ist gut bekannt, weshalb die damit erzielbaren Ergebnisse besonders gut gesteuert werden können.

Alternativ dazu kann vorgesehen sein, daß das Aufbringen des zweiten Metalles auf die am keramischen Körper anliegende Oberfläche des MMC-Körpers mittels eines stromlosen Verfahrens, wie z.B. mit dem Tampon-Verfahren, durchgeführt wird.

In diesem Fall kann die Oberfläche des MMC-Körpers gezielt und selektiv mit Metall beschichtet werden.

Daneben kann aber auch vorgesehen sein, daß das Aufbringen des zweiten Metalles auf die am keramischen Körper anliegende Oberfläche des MMC-Körpers durch Auflegen einer aus dem zweiten Metall gebildeten Folie erfolgt.

Diese Vorgangsweise ist technisch ganz besonders einfach, weil sie -außer einem Werkzeug zum Zuschneiden der Metallfolie- keine weiteren Einrichtungen (Galvanikbad, Ofen od. dgl.) erfordert.

In weiterer Ausgestaltung der Erfindung kann vorgesehen sein, daß der MMC-Körper oder der Kupfer-Körper und der keramische Körper unter Normalluft-Atmosphäre erhitzt werden.

Das erfindungsgemäße Verfahren ist so mit besonders geringem Aufwand verbunden durchführbar, insbesondere braucht die Atmosphäre des Ofens, in welchem die Erhitzung der beiden Körper durchgeführt wird, -abgesehen natürlich von der Erhitzung- in keiner weiteren Weise konditioniert werden.

Alternativ dazu kann aber auch vorgesehen sein, daß der MMC-Körper oder der Kupfer-Körper und der keramische Körper unter Schutzgas-Atmosphäre erhitzt werden, in welchem Zusammenhang es sich als besonders günstig erwiesen hat, daß die Schutzgas-Atmosphäre durch Stickstoff gebildet wird. Weiters kann vorgesehen sein, daß der MMC-Körper oder der Kupfer-Körper und der keramische Körper im Vakuum erhitzt werden.

Damit ist während des Erhitzens nahezu kein Sauerstoff in der Umgebung der beiden Körper vorhanden, sodaß sich weder auf diesen noch in der entstehenden Verbindungsschicht zwischen diesen beiden Körpern Oxide bilden können.

Gemäß einer besonders bevorzugten Ausführungsweise der Erfindung kann vorgesehen sein, daß zumindest der MMC-Körper oder der Kupfer-Körper, vorzugsweise auch der keramische Körper, während des Erhitzens von aus Graphit bestehenden Halterungen gehalten wird.

Graphit reagiert mit in seiner Umgebung befindlichen Materialien erst bei sehr hohen, beim Ablauf des erfindungsgemäßen Verfahrens gar nicht erreichten Temperaturen, sodaß die Eigenschaften des entstehenden Verbundes aus MMC-Körper und Keramik-Körper negativ beeinträchtigende Verbindungen nicht entstehen können.

Die Erfindung wird unter Bezugnahme auf die beigeschlossenen Zeichnungen näher beschrieben. Dabei zeigt:
Fig.1 einen vertikal geführten Schnitt durch einen mittels des erfindungsgemäßen Verfahrens hergestellten Verbundes umfassend einen MMC-Körper 1 und einen keramischen Körper 2 und
Fig.2 einen vertikal geführten Schnitt durch einen mittels des erfindungsgemäßen Verfahrens hergestellten Verbundes umfassend einen Kupfer-Körper 1 und einen keramischen Körper 2.

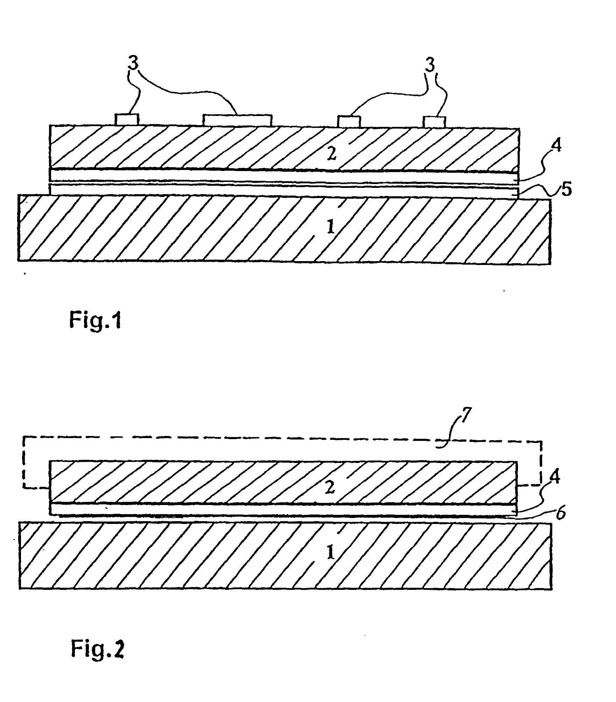

Vorerst wird lediglich auf das erfindungsgemäße Verfahren zur Verbindung eines aus einem Metall-Matrix-Composite (MMC-)Materials gebildeten Körper 1 und Fig. 1 Bezug genommen. Der MMC-Körper 1 ist dabei ein Kühlkörper und der keramische Körper 2 eine keramische Leiterplatte, auf dessen in Fig.1 oben liegender Oberfläche aus Kupfer gebildete Leiterbahnen 3 aufgebracht sind. Das erfindungsgemäße Verfahren wird unter Bezugnahme auf dieses bevorzugte Ausführungsbeispiel beschrieben, was aber die Anwendung des Verfahrens zur Verbindung von Körpern, welche andere Funktionen erfüllen, nicht ausschließt.

Die Leiterbahnen 3 werden vorzugsweise mittels eines im Stand der Technik an sich bekannten Direct-Copper-Bonding- (DCB-)Verfahrens am keramischen Substrat festgelegt. Bei einem solchen Direct-Copper-Bonding- (DCB-)Verfahren wird zwischen dem keramischen Substrat und einer Kupferfolie durch Aufbringen von Sauerstoff auf eine dieser beiden Komponenten und/oder beide Komponenten und nachfolgendes Erhitzen über die eutektische Temperatur von Cu und Cu₂O ein Cu/Cu₂O-Eutektikum gebildet, welches nach Abkühlen der beiden Komponenten diese miteinander verbindet. Bei der auf diese Weise erfolgenden Herstellung eines Kupfer-Keramik-Verbundes wird die physikalische Tatsache ausgenutzt, daß ein Cu/Cu₂O-Eutektikum sowohl Kupfer als auch Keramik sehr gut benetzt bzw. daß dieses Eutektikum nach dem Erkalten besonders gut an Keramik und Kupfer haftet und somit diese beiden Komponenten besonders innig miteinander verbindet.

Die in Fig. 1 unten liegende und am MMC-Körper 1 anliegende Oberfläche des keramischen Körpers 2 ist mit einem ersten Metall 4 beschichtet, welches Metall 4 vorzugsweise so wie die Leiterbahnen 3 aus Kupfer gebildet ist. Damit ist es möglich, auch diese Beschichtung mittels eines DCB-Verfahrens besonders innig am keramischen Körper 2 festzulegen. Es ist aber nicht ausgeschlossen, anstelle von Kupfer andere Metalle zur Bildung der Leiterbahnen 3 und/oder der auf der Unterseite liegenden Metallschicht 4 auf den keramischen Körper 2 aufzubringen, was dann allerdings mittels anderer Verfahren, wie z.B. Aufdampfen, Galvanisieren od. dgl. erfolgen muß. Wie weiter unten noch näher erläutert wird, kann die Wahl des Metalles 4 dieser Beschichtung abgestimmt werden auf das Matrix-Metall des MMC-Körpers 1 und das auf der Oberfläche dieses MMC-Körpers 1 aufgebrachte zweite Metall 5.

Die genaue Zusammensetzung des keramischen Körpers 2 ist für die Durchführung des erfindungsgemäßen Verfahrens unwesentlich, beispielsweise kann dieser Körper gebildet werden aus AlTiO₃, SiAlOₓN_{y}, AIN, BN, SiC, Si₃N₄ oder SiOₓN_{y}. Der genaue Ablauf und die Parameter des DCB-Verfahrens zur Festlegung der Leiterbahnen 3 und der Kupferschicht 4 auf dem keramischen Körper 2 müssen dem konkret verwendeten Material angepaßt werden.

Die für jedes der genannten Materialien einzusetzenden Parameter bzw. die genauen Verfahrensabläufe sind ebenfalls im Stand der Technik für sich bekannt.

Die Natur eines Metall-Matrix-Composite- (MMC-)Werkstoffes ist bekannter Stand der Technik und wurde in der Einleitung der vorliegenden Beschreibung bereits näher beschrieben, sodaß von einer diesbezüglichen ausführlichen Erläuterung Abstand genommen werden kann. Festzuhalten ist aber dennoch, daß die Durchführung des erfindungsgemäßen Verfahrens nicht auf eine bestimmte Zusammensetzung des MMC-Körpers 1 eingeschränkt ist, seine Komponenten können -unter Bedachtnahme auf die weiter unten noch erläuterte Abstimmung des Matrix-Metalles auf die anderen im Bereich der Grenzfläche zwischen MMC-Körper 1 und keramischem Körper 2 vorhandenen Metalle- grundsätzlich aus beliebigen Materialien gebildet sein. Das Verstärkungsmaterial kann beispielsweise aus SiC, AlN, AlTiO₃, SiAlOₓN_{y}, BN, Si₃N₄, SiOₓN_{y} oder Graphit gebildet sein. Das Matrix-Metall des MMC-Körpers 1 ist vorzugsweise durch Aluminium oder eine Aluminium-Legierung gebildet. Dieses Marix-Metall wird besonders bevorzugt in Kombination mit einem aus SiC gebildeten Verstärkungsmaterial eingesetzt. Andere verwendbare Matrix-Metalle sind beispielsweise Eisen, Nickel, Magnesium, Kupfer od. dgl. sowie Metallegierungen.

Die vorliegende Erfindung basiert auf der Idee, die im Stand der Technik bekannte Verlötung des keramischen Körpers 2 mit dem MMC-Körper 1 durch einen eutektischen Prozeß zu ersetzen. Das bedeutet, daß zwischen dem MMC-Körper 1 und dem keramischen Körper 2 durch Erhitzen dieser beiden Körper 1,2 ein Eutektikum gebildet wird, das sehr gut einerseits am MMC-Körper 1 und andererseits sehr gut auf der Metallschicht 4, die am keramischen Körper 2 festgelegt ist, haftet und damit zu einer innigen Verbindung dieser beiden Körper 1,2 führt.

Ein solches Eutektikum kann gebildet werden durch jene Metalle, welche zwischen dem MMC-Körper 1 und dem keramischen Körper 2 anwesend sind. Es sind dies zunächst das Matrix-Metall des MMC-Körpers 1 sowie das an der Unterseite des keramischen Körpers 2 aufgebrachte Metall 4.

Diese beiden Metalle können bei richtiger Abstimmung aufeinander besagtes Eutektikum bilden, welches zu einer innigen Verbindung der beiden Körper 1,2 untereinander fuhrt. Insbesondere wenn das Matrix-Metall des MMC-Körpers 1 durch Aluminium gebildet wird und das auf den keramischen Körper 2 aufgebrachte Metall 4 Kupfer ist, kann die erörterte Verbindung ohne Aufbringung eines zweiten Metalles 5 auf den MMC-Körper 1 erfolgen.

Gemäß einer bevorzugten Ausführungsform der Erfindung wird auf die am keramischen Körper 2 anliegende Oberfläche des MMC-Körpers 1 ein zweites Metall 5 aufgebracht, sodaß zwischen dem MMC-Körper 1 und dem keramischen Körper 2 insgesamt drei Metalle anwesend sind, nämlich neben dem schon erörteren Matrix-Metall des MMC-Körpers 1 und dem auf den keramischen Körper 2 aufgebrachten ersten Metall 4 auch das auf den MMC-Körper 1 aufgebrachte zweite Metall 5. Die Dicke des auf den MMC-Körper 1 aufgebrachten zweiten Metalles 5 ist dabei relativ dünn zu wählen, worunter in konkreten Zahlen ausgedrückt Schichtstärken im Bereich zwischen 1 und 10µm zu verstehen sind.

Die Art und Weise der Aufbringung des zweiten Metalles 5 auf den MMC-Körper 1 ist nicht erfindungswesentlich und kann daher beliebig durchgeführt werden. Als Beispiele für solche Aufbringungsmöglichkeiten können galvanische Abscheidung des Metalles 5 mittels eines entsprechenden galvanischen Verfahrens sowie stromlose Verfahren, wie z.B. das Tampon-Verfahren, mechanisches Aufpressen oder Aufreiben des Metalles angeführt werden. Diese Verfahren führen zu einer Beschichtung des MMC-Körpers 1 mit dem zweiten Metall 5, d.h. dieses wird mit der Oberfläche des MMC-Körpers 1 verbunden. Daneben ist es aber auch möglich, das zweite Metall 5 in Gestalt einer aus diesem Metall 5 gebildeten Folie vorzusehen und diese Folie auf den MMC-Körper 1 aufzulegen. Bei dieser Erfindungsvariante liegen nun zwischen dem MMC-Körper 1 und dem keramischen Körper 2 drei Metalle, nämlich das Matrix-Metall des MMC-Körpers 1, das auf den keramischen Körper 2 aufgebrachte ersten Metall 4 und das auf den MMC-Körper 1 aufgebrachte zweite Metall 5.

Hier können nun das zweite Metall 5 am MMC-Körper 1 und das erste Metall 4 am keramischen Körper 2 miteinander reagieren und ein Eutektikum bilden. Gleichzeitig reagiert aber auch das zweite Metall 5 mit dem Matrix-Metall des MMC-Körpers 1, wobei ebenfalls ein Eutektikum gebildet wird. Diese Verbindungen können dann untereinander reagieren. Im günstigsten Fall bildet sich ein ternäres Eutektikum aus, welches eine sehr innige Verbindung der beiden Körper 1,2 ergibt.

Beispiele für Metallkombinationen, die miteinander ein Eutektikum bilden und deshalb zur Bildung der drei zwischen MMC-Körper 1 und keramischem Körper 2 liegenden Metalle geeignet sind, sind in nachstehender Tabelle angeführt:

| Varianten | Al-Cu | Al-Ge | Al-Zn | Al-Sn | Al-Au | Al-Ag | Cu-Ag | Cu-Ge | Cu-Au | Cu-Zn | Cu-Sn |
|---|---|---|---|---|---|---|---|---|---|---|---|
| eutekt. | 548 | 424 | 382 | 232 | 524 | 566 | 779 | 640 | 880 | 419 | 232 |
| Temp. (°C) | | | | | 545 | | | | | | |

Nachdem das zweite Metall 5 auf den MMC-Körper 1 aufgebracht wurde, wird der keramische Körper 2 auf den MMC-Körper 1 aufgelegt und die beiden Körper 1,2 über die eutektische Temperatur des Systems gebildet aus den erörterten drei Metallen erhitzt und anschließend auf Raumtemperatur abkühlen gelassen.

Wurden die drei Metalle so gewählt, daß sie ein ternäres System mit einem gemeinsamen eutektischen Punkt bilden, ist bei der Erhitzung zwischen dem MMC-Körper 1 und dem keramischen Körper 2 ein ternäres Eutektikum entstanden, das nach Abkühlung diese beiden Körper 1,2 innig aneinander festlegt

Können nur zwei der drei Metalle ein Eutektikum bilden, so ist dieses aus zwei Metallen bestehende Eutektikum während des Erhitzens entstanden und hat sich dieses Eutektikum innig mit dem dritten Metall verbunden.

Das zur Bildung des Eutektikums notwendige Erhitzen der beiden Körper 1,2 kann unter Normalluft-Atmosphäre, unter Schutzgas-Atmosphäre (das Schutzgas kann beispielsweise durch N₂ oder Ar gebildet sein) oder in Vakuum erfolgen.

Ohne die Erfindung einzuschränken, kann folgendes konkretes Ausführungsbeispiel angegeben werden:

Der MMC-Körper 1 ist hierbei ein sog. AlSiC-Verbund, dessen Matrix-Metall aus Aluminium und dessen Verstärkungsmaterial aus SiC gebildet ist. Die am MMC-Körper 1 anliegende Oberfläche des aus Al₂O₃ gebildeten keramischen Körpers 2 wird unter Anwendung eines DCB-Verfahrens mit Kupfer beschichtet. Auf der am keramischen Körper 1 anliegenden Oberfläche des MMC-Körpers 1 wird ebenfalls eine aus Kupfer gebildete Metall-Schicht 5 festgelegt, was mittels eines galvanischen Verfahrens durchgeführt wird. Zwischen dem MMC-Körper 1 und dem keramischen Körper 2 liegen somit folgende Metalle vor: Aluminium, Kupfer (festgelegt am keramischen Körper 2) und Kupfer (festgelegt am MMC-Körper 1). Aluminium und Kupfer (festgelegt am MMC-Körper 1) bilden bei 548°C ein Eutektikum, das mit dem am keramischen Körper 2 festgelegten Kupfer reagiert, sich innig mit diesem verbindet und damit den MMC-Körper 1 mit dem keramischen Körper 2 verbindet. Da hier das am keramischen Körper 2 festgelegte Metall ebenfalls Kupfer ist, kann dieses die eutektische Temperatur nicht unter 548°C herabsetzen.

Die beiden Körper 1,2 werden so wie in Fig.1 dargestellt aufeinandergelegt und in einem Ofen auf die eutektische Temperatur von 548°C aufgeheizt und anschließend abkühlen gelassen. Besagtes Aufheizen erfolgt unter Schutzgas-Atmosphäre, welches Schutzgas durch Stickstoff gebildet wird. Der MMC-Körper 1 wird während des Verfahrens von aus Graphit bestehenden Halterungen gehalten. In ähnliche Weise kann auch der keramische Körper 2 mittels derartiger Halterungen gehalten werden.

Es wurde in weiteren Versuchen unter Beibehaltung sämtlicher anderer Werkstoffe das am MMC-Körper 1 festgelegte zweite Metall 5 zunächst durch Zink, dann durch Zinn und letztlich durch Germanium ersetzt. Beim Einsatz dieser, von Kupfer verschiedener Materialien liegt im Bereich der Grenzfläche zwischen den Körpern 1,2 ein temäres System vor, das einen eutektischen Punkt aufweist. Die Temperatur, bei welcher das Eutektikum auftritt, wurde durch Zink, Zinn und Germanium jeweils unter die eutektische Temperatur von Aluminium und Kupfer (548°C) herabgesetzt (vgl. obige Tabelle), weshalb entsprechend weniger stark erhitzt werden mußte.

In Fig.2 ist ein aus Kupfer gebildeter Körper 1 sowie ein keramischer Körper 2 dargestellt, welche mittels des erfindungsgemäßen Verfahrens miteinander verbunden werden. Unter dem hier verwendeten Begriff "Kupfer-Körper 1" ist sowohl ein massiver, relativ große Dicke aufweisender Körper als auch ein relativ dünner und damit als Kupferfolie bezeichenbarer Kupfer-Körper zu verstehen.

Das Prinzip der Verbindung eines solchen Kupfer-Körpers 1 mit dem keramischen Körper 2 liegt wieder darin, zwischen diesen beiden Körpern 1,2 ein Eutektikum auszubilden, welches nach Abkühlung gut an beiden Körpern 1,2 haftet und diese innig miteinander verbindet.

Das Metall 4, das auf den keramischen Körper 2 aufgebracht wird, muß daher ein solches sein, das mit dem Kupfer des Kupfer-Körper 1 ein Eutektikum bilden kann. Als günstig hat es sich erwiesen, dieses Metall 4 durch Aluminium zu bilden, welches -wie bereits erwähntbeim 548°C mit Kupfer das erfindungswesentliche Eutektikum bildet.

Das für die Aufbringung des Metalles 4 verwendete Verfahren ist nicht erfindungswesentlich und kann daher beliebig gewählt werden. Es muß allerdings ein solches Verfahren eingesetzt werden, mittels welchem eine gut auf dem keramischen Körper 2 haftende Metallschicht 4 erzeugt werden kann. Wird z.B. ein aus AlN gebildeter keramischer Körper 2 verwendet, so hat es sich als günstig erwiesen, die Aluminiumschicht mittels eines Druckgußprozesses aufzubringen. Bevorzugterweise wird die Aluminiumschicht mittels einer Gasdruckinfiltration auf den keramischen Körper 2 aufgebracht. Unter dem Begriff "Gasdruckinfiltration" ist im Rahmen der gegenständlichen Beschreibung ein Verfahren zu verstehen, bei welchem Aluminium durch Erhitzen über seinen Schmelzpunkt verflüssigt, auf den keramischen Körper 2 aufgegossen und durch Erhöhung des Gasdrucks der Umgebungsatmosphäre unter (Gas-)Druck gesetzt wird.

Es erfolgt dabei kein Durchdringen des keramischen Körpers 2 mit Aluminium, weil dieser dichte Konsistenz aufweist. Es wird lediglich eine oberflächliche Aluminiumschicht ausgebildet. Besagter Gasdruck kann erzeugt werden durch Kompression der Normalluft-Atmosphäre oder durch Einbringen eines von Normalluft-Atmosphäre verschiedenen Gases, insbesondere eines inerten Gase, wie beispielsweise N₂, in das Druckgefäß, innerhalb welchem besagte Gasdruckinfiltration durchgeführt wird. Das konkrete Ausmaß des aufgebrachten Gasdruckes muß dabei so gewählt werden, daß sich eine innige Festlegung der Aluminiumschicht am keramischen Körper 2 ergibt. Lediglich beispielsweise können Drücke im Bereich zwischen 60 bar bis 140 bar, vorzugsweise von 60 bar bis 80 bar, insbesondere etwa 70 bar, angegeben werden.

Es ist weiters möglich, daß der keramische Körper 2 in ein MMC-Bauteil 7 integriert ist, so wie dies mit strichlierten Linien in Fig.2 dargestellt ist. Die Herstellung eines solchen, aus einem MMC-Bauteil 7 mit in diesen integrierten keramischen Körper 2 bestehenden Verbundes kann dadurch erfolgen, daß das poröse Verstärkungsmaterial des MMC-Bauteils 7 in eine Gußform eingelegt und der keramische Körper 2 auf dieses Verstärkungsmaterial aufgelegt wird. Anschließend wird Aluminium aufgeschmolzen und in diese Gußform eingebracht. Durch Ausübung eines entsprechend hohen Druckes (erzeugbar beispielsweise durch Herstellung eines Gas-Überdruckes in der Gußform-Atmosphäre oder mittels eines mechanischen Preßstempels) wird das Aluminium einerseits in die Poren des Verstärkungsmateriales hineingedrückt (es findet also eine Infiltration dieses Verstärkungsmateriales statt) und umgießt andererseits den keramischen Körper 2. Dadurch wird dieser Körper 2 einerseits mit dem entstehenden MMC-Bauteil 7 verbunden und erhält andererseits eine Aluminiumbeschichtung 4, welche zur Ausführung des erfindungsgemäßen Verfahrens notwendig ist.

Anstelle eines Druckgußprozesses oder einer Gasdruckinfiltration kann auch ein Heißpreßverfahren angewandt werden, bei welchem eine Aluminiumfolie bei erhöhter Temperatur mittels eines Preßstempels auf die Keramik-Körper-Oberfläche aufgepreßt wird.

Eine Aluminiumschicht, die mittels eines Verfahrens aufgebracht wird, bei welchem Aluminium aufgeschmolzen und auf den keramischen Körper 2 aufgegossen wird, sollte aufgrund der starken Unterschiede in den Ausdehnungskoeffizienten zwischen Keramik und Aluminium möglichst dünn bleiben. Da das Aluminium von der schmelzflüssigen Phase in den festen Zustand übergeht und die Verbindung im oberen Temperaturbereich stattfindet, wird eine dicke Aluminiumschicht starke Spannungen auf die Übergangsschicht zwischen Keramik und Aluminium ausüben, sodaß bei größeren Flächen Risse in der Keramik auftreten können. Die Aluminiumschicht wird zur Vermeidung derartiger Probleme dünn, soll heißen im Bereich zwischen 10 und 100µm, gehalten.

Nach erfolgter Aufbringung des Metalles 4 auf den keramischen Körper 2 wird dieser auf den Kupfer-Körper 1 aufgelegt und diese beiden Körper 1,2 über die eutektische Temperatur des Systems gebildet aus dem Kupfer des Kupfer-Körpers 1 und dem auf die Oberfläche des keramischen Körpers 2 aufgebrachten Metalles 4 erhitzt und anschließend auf Raumtemperatur abkühlen gelassen. Dabei entsteht zwischen den beiden Körpern 1,2 ein Cu-Al-Eutektikum, das die beiden Körper 1,2 innig miteinander verbindet.

Bevor die beiden Körper 1,2 aufeinandergelegt und erhitzt werden, kann auf die Metallschicht 4 des keramischen Körpers 2 eine dünne Kupferschicht 6, beispielsweise mittels elektrochemischen Methoden, wie insbesondere mittels eines galvanischen Verfahrens aufgebracht werden. Es liegt dann eine ähnliche Situation vor, wie beim im Zusammenhang mit der Verbindung eines MMC-Körpers mit einem keramischen Körper gegebenen konkreten Ausführungsbeispiel: Diese Kupferschicht bildet mit der Aluminiumschicht ein Eutektikum, das mit dem Kupfer des Kupfer-Körpers 1 reagiert und sich dabei innig mit diesem verbindet.

## Patentansprüche

1. Verfahren zur Verbindung eines aus einem Metall-Matrix-Composite- (MMC-) Material gebildeten Körpers (1), insbesondere eines Kühlkörpers, oder eines aus Kupfer gebildeten Körpers (1) mit einem keramischen Körper (2), insbesondere einer keramischen Leiterplatte, wobei die am MMC-Körper (1) oder Kupfer-Körper (1) anliegende Oberfläche des keramischen Körpers (2) mit einem ersten Metall (4) beschichtet wird, **dadurch gekennzeichnet, daß** der keramische Körper (2) auf den MMC- oder Kupfer-Körper (1) aufgelegt wird und daß die beiden Körper (1,2) über die eutektische Temperatur des Systems gebildet aus dem Matrix-Metall des MMC-Körpers (1) oder dem Kupfer des Kupfer-Körpers (1) und dem auf die Oberfläche des keramischen Körpers (2) aufgebrachten ersten Metall (4) erhitzt und anschließend auf Raumtemperatur abkühlen gelassen werden.

2. Verfahren nach Anspruch 1, **dadurch gekennzeichnet, daß** vor dem Auflegen des keramischen Körpers (2) auf den MMC-Körper (1) auf die am keramischen Körper (2) anliegende Oberfläche des MMC-Körpers (1) ein zweites Metall (5) aufgebracht wird und daß die beiden Körper (1,2) über die eutektische Temperatur des Systems gebildet aus dem Matrix-Metall des MMC-Körpers (1), dem auf die Oberfläche des keramischen Körpers (2) aufgebrachten ersten Metall (4) und dem auf die Oberfläche des MMC-Körpers (1) aufgebrachten zweiten Metall (5) erhitzt und anschließend auf Raumtemperatur abkühlen gelassen werden.

3. Verfahren nach Anspruch 1 oder 2, **dadurch gekennzeichnet, daß** das Matrix-Metall des MMC-Körpers (1) durch Aluminium oder eine Aluminiumlegierung gebildet wird.

4. Verfahren nach Anspruch 1, 2 oder 3, **dadurch gekennzeichnet, daß** das Verstärkungsmaterial des MMC-Körpers (1) durch eine Keramik, insbesondere durch SiC gebildet wird.

5. Verfahren nach einem der Ansprüche 1 bis 4, **dadurch gekennzeichnet, daß** die am MMC-Körper (1) anliegende Oberfläche des keramischen Körpers (2) mit Kupfer beschichtet wird.

6. Verfahren nach Anspruch 5, **dadurch gekennzeichnet, daß** die Beschichtung der am MMC-Körper (1) anliegenden Oberfläche des keramischen Körpers (2) mittels eines Direct-Copper-Bonding- (DCB-)Verfahrens durchgerührt wird.

7. Verfahren nach Anspruch 1, **dadurch gekennzeichnet, daß** die am Kupfer-Körper (1) anliegende Oberfläche des keramischen Körpers (2) mit Aluminium beschichtet wird.

8. Verfahren nach Anspruch 7, **dadurch gekennzeichnet, daß** auf die Aluminiumschicht (4) eine Kupferschicht (6) aufgebracht wird, beispielsweise mittels elektrochemischen Methoden, wie insbesondere mittels eines galvanischen Verfahrens.

9. Verfahren nach einem der Ansprüche 2 bis 6, **dadurch gekennzeichnet, daß** auf die am keramischen Körper (2) anliegende Oberfläche des MMC-Körpers (1) Kupfer aufgebracht wird.

10. Verfahren nach einem der Ansprüche 2 bis 6, **dadurch gekennzeichnet, daß** auf die am keramischen Körper (2) anliegende Oberfläche des MMC-Körpers (1) Zink, Zinn, Germanium od. dgl. aufgebracht wird.

11. Verfahren nach Anspruch 9 oder 10, **dadurch gekennzeichnet, daß** das Aufbringen des zweiten Metalles (5) auf die am keramischen Körper (2) anliegende Oberfläche des MMC-Körpers (1) mittels eines galvanischen Verfahrens durchgeführt wird.

12. Verfahren nach Anspruch 9 oder 10, **dadurch gekennzeichnet, daß** das Aufbringen des zweiten Metalles (5) auf die am keramischen Körper (2) anliegende Oberfläche des MMC-Körpers (1) mittels eines stromlosen Verfahrens, wie z.B. mit dem Tampon-Verfahren durchgeführt wird.

13. Verfahren nach Anspruch 9 oder 10, **dadurch gekennzeichnet, daß** das Aufbringen des zweiten Metalles (5) auf die am keramischen Körper (2) anliegende Oberfläche des MMC-Körpers (1) durch Auflegen einer aus dem zweiten Metall (5) gebildeten Folie erfolgt.

14. Verfahren nach einem Ansprüche 1 bis 13, **dadurch gekennzeichnet, daß** der MMC-Körper (1) oder der Kupfer-Körper (1) und der keramische Körper (2) unter Normalluft-Atmosphäre erhitzt werden.

15. Verfahren nach einem Ansprüche 1 bis 13, **dadurch gekennzeichnet, daß** der MMC-Körper (1) oder der Kupfer-Körper (1) und der keramische Körper (2) unter Schutzgas-Atmosphäre erhitzt werden.

16. Verfahren nach Anspruch 15, **dadurch gekennzeichnet, daß** die Schutzgas-Atmosphäre durch Stickstoff oder Argon gebildet wird.

17. Verfahren nach einem Ansprüche 1 bis 13, **dadurch gekennzeichnet, daß** der MMC-Körper (1) oder der Kupfer-Körper (1) und der keramische Körper (2) in Vakuum erhitzt werden.

18. Verfahren nach einem der vorstehenden Ansprüche, **dadurch gekennzeichnet, daß** zumindest der MMC-Körper (1) oder der Kupfer-Körper (1), vorzugsweise auch der keramische Körper (2), während des Erhitzens von aus Graphit bestehenden Halterungen gehalten wird.

## Claims

1. A method for attaching a body (1) which is made of a metal-matrix-composite material (MMC), especially a heat sink, or a body (1) made of copper with a ceramic body (2), especially a ceramic printed circuit board, with the surface of the ceramic body (2) which rests on the MMC body (1) or the copper body (1) being coated with a first metal (4), **characterized in that** the ceramic body (2) is placed on the MMC or copper body (1) and that the two bodies (1, 2) are heated over the eutectic temperature of the system formed from the matrix metal of the MMC body (1) or the copper of the copper body (1) and the first metal (4) applied to the surface of the ceramic body (2) and are allowed to cool off to room temperature.

2. A method as claimed in claim 1, **characterized in that** prior to placing the ceramic body (2) on the MMC body (1) a second metal (5) is applied to the surface of the MMC body (1) resting on the ceramic body (2) and that the two bodies (1, 2) are heated over the eutectic temperature of the system formed from the matrix metal of the MMC body (1), the first metal (4) applied to the surface of the ceramic body (2) and the second metal (5) applied to the surface of the MMC body (1), and are then allowed to cool off to room temperature.

3. A method as claimed in claim 1 or 2, **characterized in that** the matrix metal of the MMC body (1) is formed by aluminum or an aluminum alloy.

4. A method as claimed in claim 1, 2 or 3, **characterized in that** the reinforcing material of the MMC body (1) is formed by a ceramic material, especially by SiC.

5. A method as claimed in one of the claims 1 to 4, **characterized in that** the surface of the ceramic body (2) resting on the MMC body (1) is coated with copper.

6. A method as claimed in claim 5, **characterized in that** the coating of the surface of the ceramic body (2) resting on the MMC body (1) is carried out by means of a direct-copper-bonding (DCB) method.

7. A method as claimed in claim 1, **characterized in that** the surface of the ceramic body (2) resting on the copper body (1) is coated with aluminum.

8. A method as claimed in claim 7, **characterized in that** a copper layer (6) is applied onto the aluminum layer (4), e.g. by means of electrochemical processes such as an electroplating process in particular.

9. A method as claimed in one of the claims 2 to 6, **characterized in that** copper is applied onto the surface of the MMC body (1) resting on the ceramic body (2).

10. A method as claimed in one of the claims 2 to 6, **characterized in that** zinc, tin, germanium or the like is applied onto the surface of the MMC body (1) resting on the ceramic body (2).

11. A method as claimed in claim 9 or 10, **characterized in that** the application of the second metal (5) onto the surface of the MMC body (1) resting on the ceramic body (2) occurs by means of an electroplating process.

12. A method as claimed in claim 9 or 10, **characterized in that** the application of the second metal (5) onto the surface of the MMC body (1) resting on the ceramic body (2) occurs by means of a currentless process such as the tampon process.

13. A method as claimed in claim 9 or 10, **characterized in that** the application of the second metal (5) onto the surface of the MMC body (1) resting on the ceramic body (2) occurs by means of applying a film made of the second metal (5).

14. A method as claimed in one of the claims 1 to 13, **characterized in that** the MMC body (1) or the copper body (1) and the ceramic body (2) are heated under normal air atmosphere.

15. A method as claimed in one of the claims 1 to 13, **characterized in that** the MMC body (1) or the copper body (1) and the ceramic body (2) are heated under a protective gas atmosphere.

16. A method as claimed in claim 15, **characterized in that** the protective gas atmosphere is formed by nitrogen or argon.

17. A method as claimed in one of the claims 1 to 13, **characterized in that** the MMC body (1) or the copper body (1) and the ceramic body (2) are heated under vacuum.

18. A method as claimed in one of the preceding claims, **characterized in that** at least the MMC body (1) or the copper body (1), and preferably also the ceramic body (2), is held during the heating by holding devices made of graphite.

## Revendications

1. Procédé de liaison d'un élément CMM (1) réalisé en un matériau composite à matrice métallique, notamment d'un élément refroidisseur, ou d'un élément réalisé en cuivre (1), avec un élément céramique (2), notamment avec un circuit imprimé céramique, la surface de l'élément céramique (2) adjacente à l'élément CMM (1) ou à l'élément en cuivre (1) étant recouverte d'une couche d'un premier métal (4), **caractérisé en ce qu'**on dépose l'élément céramique (2) sur l'élément CMM ou en cuivre (1) et qu'on chauffe les deux éléments (1, 2) au-delà de la température eutectique du système formé par le métal de la matrice de l'élément CMM (1) ou par le cuivre de l'élément en cuivre (1) et par le premier métal (4) déposé sur la surface de l'élément céramique (2) et qu'on les laisse ensuite refroidir à température ambiante.

2. Procédé selon la revendication 1, **caractérisé en ce qu'**on dépose un deuxième métal (5) sur la surface de l'élément CMM (1) adjacente à l'élément céramique (2) avant de placer l'élément céramique (2) sur l'élément CMM (1) et qu'on chauffe les deux éléments (1, 2) au-delà de la température eutectique du système formé par le métal de la matrice de l'élément CMM (1), par le premier métal (4) déposé sur la surface de l'élément céramique (2) et par le deuxième métal (5) déposé sur la surface de l'élément CMM (1) et qu'on les laisse ensuite refroidir à température ambiante.

3. Procédé selon la revendication 1 ou 2, **caractérisé en ce que** le métal de la matrice de l'élément CMM (1) est de l'aluminium ou un alliage d'aluminium.

4. Procédé selon la revendication 1, 2 ou 3, **caractérisé en ce que** le matériau de renfort de l'élément CMM (1) est réalisé en céramique, notamment en SiC.

5. Procédé selon l'une quelconque des revendications 1 à 4, **caractérisé en ce que** la surface de l'élément céramique (2) adjacente à l'élément CMM (1) est recouverte d'une couche de cuivre.

6. Procédé selon la revendication 5, **caractérisé en ce que** l'enduction de la surface de l'élément céramique (2) adjacente à l'élément CMM (1) est réalisée en utilisant le procédé du Direct Copper Bonding (DCB).

7. Procédé selon la revendication 1, **caractérisé en ce que** la surface de l'élément céramique (2) adjacente à l'élément en cuivre (1) est recouverte d'une couche d'aluminium.

8. Procédé selon la revendication 7, **caractérisé en ce qu'**on dépose sur la couche d'aluminium (4) une couche de cuivre (6) en utilisant par exemple des méthodes électrochimiques, notamment la galvanoplastie.

9. Procédé selon l'une quelconque des revendications 2 à 6, **caractérisé en ce qu'**on dépose du cuivre sur la surface de l'élément CMM (1) adjacente à l'élément céramique (2).

10. Procédé selon l'une quelconque des revendications 2 à 6, **caractérisé en ce qu'**on dépose du zinc, de l'étain, du germanium ou similaire sur la surface de l'élément CMM (1) adjacente à l'élément céramique (2).

11. Procédé selon la revendication 9 ou 10, **caractérisé en ce que** le second métal (5) est déposé par galvanoplastie sur la surface de l'élément CMM (1) adjacente à l'élément céramique (2).

12. Procédé selon la revendication 9 ou 10, **caractérisé en ce que** le second métal (5) est déposé par un procédé electroless, par un procédé au tampon par exemple, sur la surface de l'élément CMM (1) adjacente à l'élément céramique (2).

13. Procédé selon la revendication 9 ou 10, **caractérisé en ce que** le second métal (5) est déposé sur la surface de l'élément CMM (1) adjacente à l'élément céramique (2) sous forme d'un film réalisé dans ce deuxième métal (5).

14. Procédé selon l'une quelconque des revendications 1 à 13, **caractérisé en ce qu'**on chauffe l'élément CMM (1) ou l'élément en cuivre (1) et l'élément céramique (2) sous atmosphère normale.

15. Procédé selon l'une quelconque des revendications 1 à 13, **caractérisé en ce qu'**on chauffe l'élément CMM (1) ou l'élément en cuivre (1) et l'élément céramique (2) sous atmosphère contrôlée.

16. Procédé selon la revendication 15, **caractérisé en ce que** l'atmosphère contrôlée est formée par de l'azote ou de l'argon.

17. Procédé selon l'une quelconque des revendications 1 à 13, **caractérisé en ce qu'**on chauffe l'élément CMM (1) ou l'élément en cuivre (1) et l'élément céramique (2) sous vide.

18. Procédé selon l'une quelconque des revendications précédentes, **caractérisé en ce que** du moins l'élément CMM (1) ou l'élément en cuivre (1), de préférence aussi l'élément céramique (2), sont retenus par des fixations en graphite pendant la chauffe.
